# EUROPÄISCHE PATENTSCHRIFT

(11) **EP 2 839 724 B1**
(45) Veröffentlichungstag und Bekanntmachung des Hinweises auf die Patenterteilung: **14.09.2016**
(21) Anmeldenummer: 13708340.8
(22) Anmeldetag: 08.02.2013
(51) Int. Cl.: H05K 7/20

(54) **KÜHLGERÄT FÜR DIE SCHALTSCHRANKKÜHLUNG**
COOLING APPARATUS FOR CONTROL CABINET COOLING
APPAREIL DE REFROIDISSEMENT POUR LE REFROIDISSEMENT D'ARMOIRES ÉLECTRIQUES

(30) Priorität: 19.04.2012 DE 102012007707
(43) Veröffentlichungstag der Anmeldung: 25.02.2015
(73) Patentinhaber: RITTAL GmbH & Co. KG, 35745 Herborn (DE)
(72) Erfinder: NICOLAI, Michael, 35466 Rabenau (DE); DÖRRICH, Martin, 35756 Mittenaar (DE); BECKER, Dieter, 35713 Eschenburg (DE); MEYER, Andreas, 35460 Staufenberg/Hess (DE)
(74) Vertreter: Angerhausen, Christoph
(86) Internationale Anmeldenummer: PCT/DE2013/000074
(87) Internationale Veröffentlichungsnummer: WO 2013/156011

(56) Entgegenhaltungen:
- EP-A2- 0 353 744
- WO-A2-2008/039773
- DE-B3-102005 005 296

## Beschreibung

Die Erfindung betrifft ein Kühlgerät für die Schaltschrankkühlung, mit einer Lufteinlassseite für Warmluft und einer Luftauslassseite für gekühlte Luft, wobei zwischen der Lufteinlassseite und der Luftauslassseite ein Wärmetauscher und mindestens eine Lüftereinheit mit einem Radiallüfter angeordnet ist, und wobei die Lüftereinheit zwischen der Lufteinlassseite und der Luftauslassseite einen Luftstrom durch den Wärmetauscher mit einer Hauptströmungsrichtung erzeugt, wobei die Lüftereinheit in Hauptströmungsrichtung hinter dem Wärmetauscher angeordnet ist. Ein derartiges Kühlgerät ist aus der WO 2012/116724 A1 bekannt. Ein ähnliches Kühlgerät beschreibt auch die WO 2008/039773 A2.

Gattungsgemäße Kühlgeräte finden insbesondere in Rechenzentren mit einem Kaltgang und einem Warmgang Anwendung, wobei der Kaltgang von dem Warmgang gerade durch eine Reihe von nebeneinander aufgestellten Schaltschränken abgetrennt ist. Gattungsgemäße Kühlgeräte sind dabei insbesondere als Inline-Geräte ausgebildet und dazu in die Schaltschrankreihe eingegliedert. Diese Kühlgeräte saugen über ihre Lufteinlassseite die Warmluft aus dem Warmgang an und blasen die gekühlte Luft über ihre Luftauslassseite in den Kaltgang. Für den Abtransport der Verlustleistung der in den Schaltschränken aufgenommenen Komponenten wird die gekühlte Luft über eine dem Kaltgang zugewandte Seite der Schaltschränke aus dem Kaltgang angesogen, durch die Schaltschränke geleitet, wo sie sich erwärmt, und in den Warmgang ausgeblasen.

Um den Energieverbrauch gattungsgemäßer Kühlgeräte so gering wie möglich zu halten, hat es sich bewährt, die Lüftereinheiten mit Radiallüftern, insbesondere mit solchen, die rückwärts gekrümmte Schaufeln aufweisen, zu bestücken. Diese haben jedoch den Nachteil, dass sie von Haus aus nicht für eine lineare Luftführung geeignet sind. Soll das Kühlgerät daher als Inline-Gerät der vorbeschriebenen Art verwendet werden, ist es bisher bei Kühlgeräten, welche Radiallüfter einsetzen, nicht möglich gewesen, den Luftstrom linear zwischen der Lufteinlassseite des Kühlgeräts und der Luftauslassseite des Kühlgeräts zu führen. Es ist insbesondere bisher kein gattungsgemäßes Kühlgerät bekannt, bei dem die Lufteinlassseite und die Luftauslassseite parallele Seiten des Kühlgeräts, beispielsweise eine Rückseite und eine Vorderseite des Kühlgeräts, sind. Vielmehr bedingt die Verwendung der Radiallüfter bei den bekannten Kühlgeräten stets, dass die gekühlte Luft an der Luftauslassseite seitlich, das heißt unter einem Winkel von 90° zur Hauptströmungsrichtung aus dem Kühlgerät ausgeblasen wird. Um diesen Luftauslass zu ermöglichen, ist es stets notwendig, dass das Kühlgerät im Kaltgang über die Fronten der Schaltschränke hinausragt. Dies ist im Hinblick auf die Luftführung im Kaltgang sowie die im Kaltgang üblicherweise beengten Platzverhältnisse nachteilig.

Es ist daher die Aufgabe der Erfindung, ein gattungsgemäßes Kühlgerät für die Schaltschrankkühlung bereitzustellen, das dazu geeignet ist, im Inline-Betrieb an seiner Luftauslassseite für gekühlte Luft fluchtend mit den Schaltschränken aufgestellt werden zu können.

Diese Aufgabe wird von einem gattungsgemäßen Kühlgerät gelöst, das sich dadurch auszeichnet, dass die Lüftereinheit eine Luftleitgeometrie aufweist, so dass aus dem Radiallüfter austretende Luft in die Hauptströmungsrichtung umgeleitet wird und somit in Hauptströmungsrichtung aus dem Kühlgerät herausströmt.

Vorzugsweise weist die Lüftereinheit eine im Wesentlichen quadratische Lüfterbox auf, in der der Radiallüfter aufgenommen ist, wobei die Lüfterbox an mindestens einer von vier parallel zu der Hauptströmungsrichtung und parallel zu einer Drehachse des Radiallüfters ausgerichteten Seiten einen Luftauslass aufweist.

Bei dieser Ausführungsform kann weiterhin vorgesehen sein, dass die Luftleitgeometrie an den Luftauslass oder die Luftauslässe der Lüfterbox angrenzt und den Luftauslass oder die Luftauslässe von einer Saugseite des Radiallüfters fluidisch abgrenzt, so dass die aus dem Luftauslass oder den Luftauslässen austretende Luft von der Saugseite des Radiallüfters weggeführt wird.

Bei einer Ausführungsform der Erfindung, bei welcher die Lüfterbox im Wesentlichen quadratisch ist und an jeder der vier parallel zu der Hauptströmungsrichtung ausgerichteten Seiten der Lüfterbox ein Luftauslass ausgebildet ist, kann vorgesehen sein, dass die Luftleitgeometrie als ein Trichter, der um die vier parallel zu der Hauptströmungsrichtung ausgerichteten Seiten herum angeordnet ist, ausgebildet ist. Anstelle eines geschlossenen, rotationssymmetrischen Trichters, kann auch ein Teiltrichter vorgesehen sein, so dass dem Luftauslass als Luftleitgeometrie ein Trichtersegment zugeordnet ist.

Bei der bevorzugten Ausführungsform weist die Luftleitgeometrie im Querschnitt eine 90°-Krümmung auf. Im einfachsten Fall weist die Luftleitgeometrie einen ersten Abschnitt auf, der sich im Wesentlichen senkrecht zu zumindest einer von den vier parallel zu der Hauptströmungsrichtung ausgerichteten Seiten erstreckt und über die die Luftleitgeometrie mit der Lüfterbox in Verbindung steht. Zweckmäßigerweise ist dieser Abschnitt in Hauptströmungsrichtung zwischen der Saugseite der Lüfterbox und den Luftauslässen mit der Lüfterbox verbunden. Dieser erste Abschnitt kann in einem möglichst großen Radius in einen zweiten Abschnitt übergehen, der senkrecht zu dem ersten Abschnitt ausgerichtet ist. Der Radius sollte so groß wie möglich sein, um den Druckverlust so gering wie möglich zu halten. Andererseits wird der maximale Umlenkradius durch die im Inneren des Kühlgeräts vorhandenen Platzverhältnisse vorgegeben sein. Der Umlenkradius kann jedoch auch im Verlauf der Luftleitgeometrie variieren.

Bei einer Ausführungsform der Erfindung weist das Kühlgerät eine Mehrzahl der Lüftereinheiten auf, wobei benachbarte Lüftereinheiten derart zueinander vermittelt angeordnet sind, dass sie entlang ihrer jeweiligen Luftleitgeometrie zumindest abschnittsweise aneinander grenzen. Üblicherweise sind die Lüftereinheiten an der Luftauslassseite des Kühlgeräts in vertikaler Richtung aneinander gereiht. Vorzugsweise grenzen die Luftleitgeometrie benachbarter Lüftereinheiten entlang ihrer freien Enden aneinander um einen weitestgehend homogenen und gleichgerichteten Luftstrom an der Luftauslassseite zu erreichen.

Bei einer weiteren Ausführungsform der Erfindung ist vorgesehen, dass bei benachbarten Lüftereinheiten ein Trennelement, das sich zwischen gegenüberliegenden Seiten der benachbarten Lüftereinheiten erstreckt, die Luftauslässe der benachbarten Lüftereinheiten von den Saugseiten der benachbarten Lüftereinheiten fluidisch dicht abtrennt. Auf diese Weise wird eine effektive Abschottung der gemeinsamen Ansaugseite von der gemeinsamen Ausblassseite der Lüftereinheiten erreicht.

Es kann weiterhin vorgesehen sein, dass das Kühlgerät ein Rahmengestell aufweist, wobei das Rahmengestell an der Luftauslassseite eine Einbauöffnung mit einer horizontalen Weite aufweist, die kleiner als eine horizontale Weite der Lüftereinheiten ist, oder die der horizontalen Weite der Lüftereinheiten entspricht, wobei die Lüftereinheiten in vertikaler Richtung übereinander an dem Rahmengestell montiert sind, und wobei sich das Trennelement über die gesamte horizontale Weite des Kühlgeräts erstreckt.

Weitere Einzelheiten der Erfindung werden anhand der nachstehenden Figuren erläutert. Dabei zeigt:
- Figur 1: eine horizontale Querschnittsansicht einer Schaltschrankreihe mit einem InlineKühlgerät gemäß dem Stand der Technik;
- Figur 2: eine Querschnittsansicht einer erfindungsgemäßen Lüftereinheit gemäß einer Ausführungsform der Erfindung;
- Figur 3: eine perspektivische Ansicht der Lüftereinheit gemäß Figur 2;
- Figur 4: eine Querschnittsansicht einer Ausführungsform des erfindungsgemäßen Kühlgeräts; und
- Figur 5: eine perspektivische Ansicht des Kühlgeräts gemäß Figur 4.

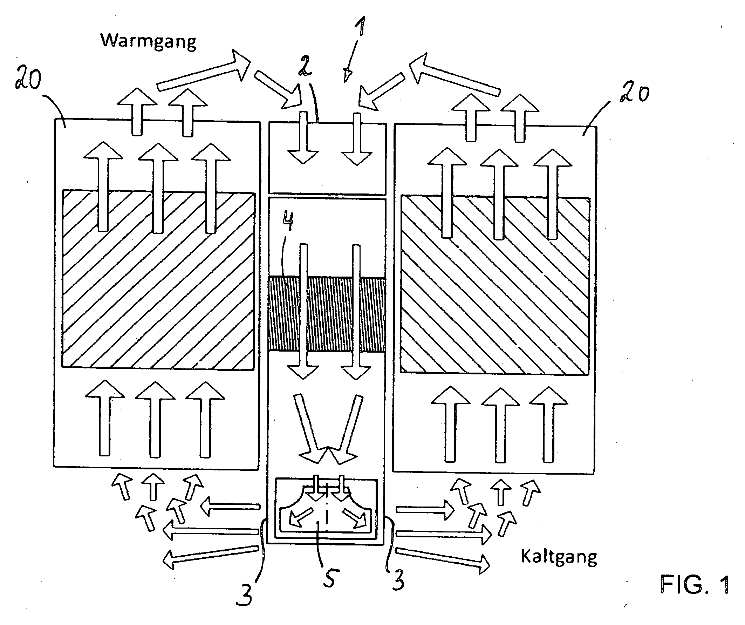

Figur 1 zeigt einen horizontalen Querschnitt durch eine Reihe von Schaltschränken 20, in die ein Kühlgerät 1, welches nach dem Stand der Technik ausgeführt ist, integriert ist. Es ist zu erkennen, dass das Kühlgerät 1 auf Seiten des Kaltgangs über die Frontseiten der Schaltschränke 20, über welche diese die von dem Kühlgerät 1 bereit gestellte Kaltluft ansaugen, hinaus ragt. Dadurch, dass die Front des Kühlgeräts 1 in den Kaltgang hinein ragt, stellt das Kühlgerät 1 nach dem Stand der Technik ein Hindernis dar, welches den Kaltgang lokal verengt und damit auch die Luftverteilung innerhalb des Kaltgangs nachteilig beeinflusst. Während die Schaltschränke 20 über ihre Rückseite erwärmte Luft in den Warmgang ausblasen, wird die erwärmte Luft über die Lufteinlassseite 2 des Kühlgeräts 1 angesogen, durch den Wärmetauscher 4 geleitet und mit Hilfe der Lüftereinheiten 5, welche einen Radiallüfter aufweisen, seitlich durch eine erste und eine zweite Luftauslassseite 3 ausgeblasen.

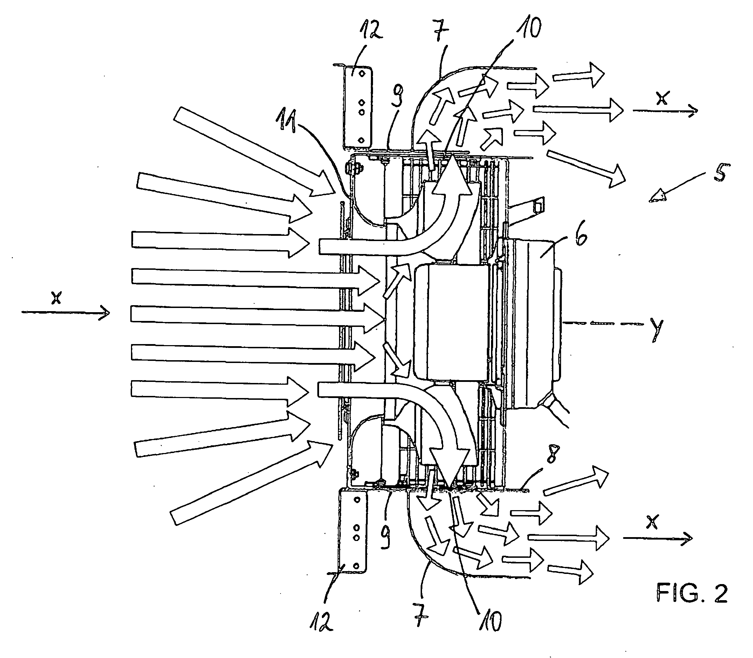

Figur 2 zeigt die Querschnittsansicht einer Lüftereinheit 5 gemäß einer Ausführungsform der Erfindung. Die erfindungsgemäße Lüftereinheit 5 zeichnet sich dadurch aus, dass die über die Saugseite 11 angesogene Luft zwar wie für Radiallüfter typisch seitlich über die Seiten 9 der Lüfterbox 8 ausgeströmt wird, sich an diese Seiten 9 jedoch Luftleitgeometrien 7 anschließen, welche die Strömungsrichtung der über die Luftauslässe 10 in den Seiten 9 ausströmenden Luft um 90° in Richtung der Hauptströmungsrichtung x umlenken. Die an der Vorderseite der Lüftereinheit 5 ausströmende Luft weist somit dieselbe Strömungsrichtung x wie die an der Saugseite 11 angesogene Luft auf. Die erfindungsgemäße Lüftereinheit 5 eignet sich daher für den linearen Lufttransport zwischen dem Warmgang und dem Kaltgang (vgl. Figur 1). An der Lüfterbox 8 sind weiterhin Trennelemente 12 vorgesehen, mit Hilfe welcher weitere Lüftereinheiten 5 mit entsprechenden Trennelementen 12 sowie Luftleitgeometrien 7 derart aneinander gereiht werden können, dass sich eine fluidisch dichte Abtrennung zwischen einer gemeinsamen Saugseite 11 der aneinander gereihten Lüftereinheiten 5 und einer gemeinsamen Luftausströmseite ergibt.

Die Luftleitgeometrie 7 erstreckt sich an ihrer Anschlussstelle zu der Seite 9 der Lüfterbox 8 zunächst im Wesentlichen senkrecht, um sogleich eine 90°-Richtungsänderung auszuführen, wobei die Luftleitgeometrie 7 im Bereich ihres freien Endes in einen Abschnitt übergeht, der sich im Wesentlichen parallel zu der Hauptströmungsrichtung x erstreckt. Der Endabschnitt der Luftleitgeometrie 7 erstreckt sich auf derselben Höhe wie das freie Ende des Trennelements 12, wodurch erreicht wird, dass bei der Aneinanderreihung gleichartiger Lüftereinheiten 5 neben den Trennelementen 12 auch die Luftleitgeometrien 7 zumindest in ihren Endbereichen formschlüssig aneinander liegen. Ebenfalls eingezeichnet ist die Drehachse y des Radiallüfters 6, welche sich parallel zu der Hauptströmungsrichtung x erstreckt.

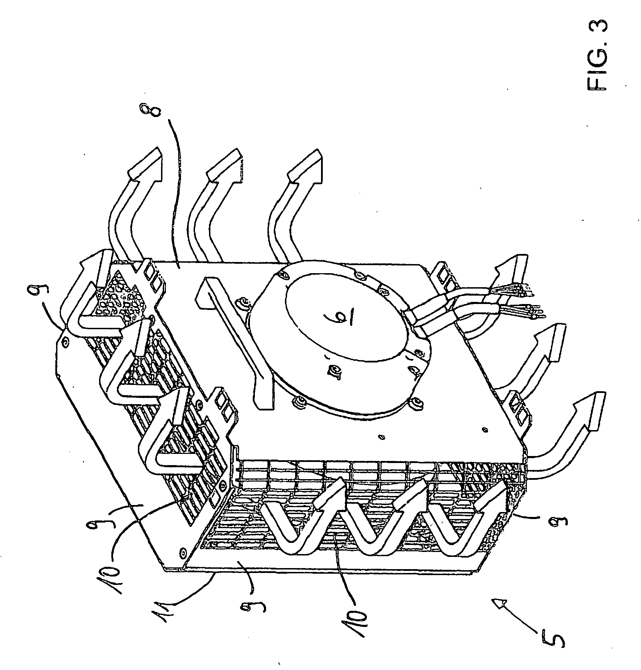

Figur 3 zeigt eine perspektivische Ansicht der Lüftereinheit 5 gemäß Figur 2, wobei zur besseren Veranschaulichung die Luftleitgeometrien 7 (siehe Figur 2) weggelassen wurden. Die Lüftereinheit 5 weist einen Radiallüfter 6 auf, der in einer Lüfterbox 8 aufgenommen ist. Die Lüfterbox 8 ist im Wesentlichen quaderförmig ausgebildet und weist vier Seiten 9 auf, über welche die von dem Radiallüfter 6 angesogene Luft ausströmen kann. Mit Hilfe der nicht eingezeichneten Luftleitgeometrien wird die Luft um 90° umgelenkt, was durch die eingezeichneten Pfeile dargestellt ist. Es ist weiterhin zu erkennen, dass sich die Luftauslässe 10 in den Seiten 9, durch welche die von dem Radiallüfter 6 angesogene Luft ausgetrieben wird, nicht über die gesamte Fläche der Seite 9 erstrecken. In dem Bereich der Seite 9 in welchem der jeweilige Luftauslass 10 nicht ausgebildet ist, kann die Luftleitgeometrie auf der Lüfterbox 8 befestigt werden, wodurch eine effektive Abtrennung der Luftauslässe 10 von der Saugseite 11 der Lüftersbox 8 erreicht wird.

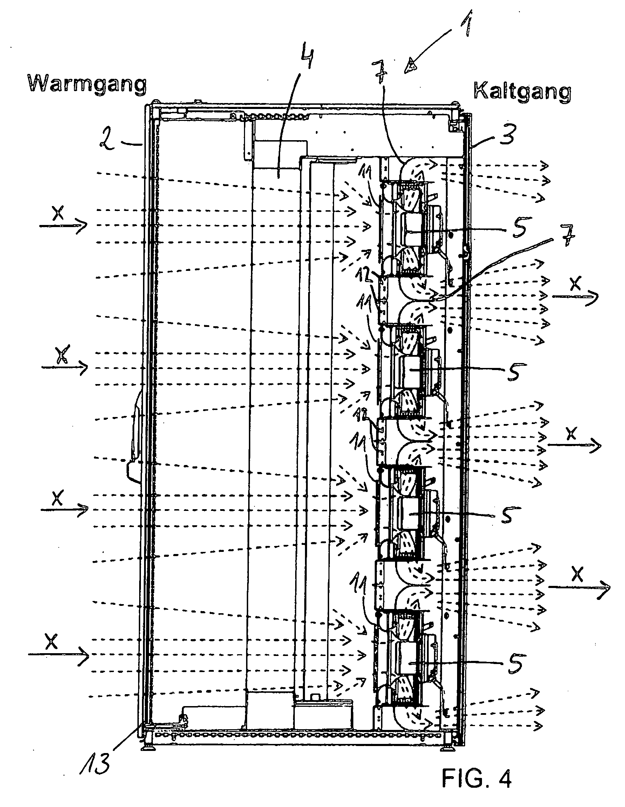

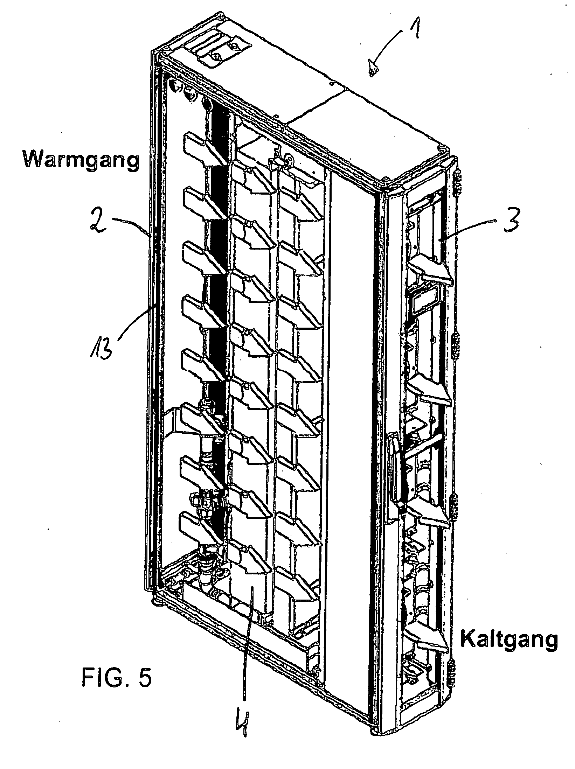

Die Figur 4 zeigt eine Querschnittsansicht einer Ausführungsform des erfindungsgemäßen Kühlgeräts 1, in welchem vertikal übereinander vier Lüftereinheiten 5 angeordnet sind. Das Kühlgerät 1 weist eine Lufteinlassseite 2 für Warmluft und eine Luftauslassseite 3 für gekühlte Luft auf. Die Lüftereinheiten 5 saugen Luft aus dem Warmgang durch die Lufteinlassseite 2, durch den Wärmetauscher 4 und eventuell einen nachgeschalteten Tropfenabscheider an und blasen sie durch die Luftauslassseite 3 in den Kaltgang. Es ist zu erkennen, dass sowohl an der Lufteinlassseite 2 als auch an der Luftauslassseite 3 die Hauptströmungsrichtung x identisch ist. Es ist weiterhin zu erkennen, dass die Lüftereinheiten 5 über ihre Trennelemente 12 sowie die Luftleitgeometrien 7 derart übereinander angeordnet sind, dass sich eine effektive Abtrennung zwischen der Saugseite 11 der Lüftereinheiten 5 und der Luftauslassseite 3 ergibt. In der Zusammenschau der Figuren 4 und 5 ist zu erkennen, dass das erfindungsgemäße Kühlgerät 1 vorzugsweise in ein Rahmengestell 13 integriert ist, wobei das Rahmengestell 13 für ein erfindungsgemäßes Kühlgerät 1 nicht nur in der Höhe an die Schaltschränke 20 der Schaltschrankreihe in welche das Kühlgerät 1 integriert ist, angepasst sein kann, sondern auch hinsichtlich seiner Tiefe parallel zur Luftströmungsrichtung x. Es ist somit nicht mehr notwendig, dass die Vorderseite des Kühlgeräts 1, an welchem bei erfindungsgemäßen Kühlgeräten die Luftauslassseite 3 angeordnet ist, über die Frontseite der Schaltschränke 20 hinaus ragt.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Kühlgerät
- 2: Lufteinlassseite
- 3: Luftauslassseite
- 4: Wärmetauscher
- 5: Lüftereinheit
- 6: Radiallüfter
- 7: Luftleitgeometrie
- 8: Lüfterbox
- 9: Seite der Lüfterbox
- 10: Luftauslass
- 11: Saugseite
- 12: Trennelement
- 13: Rahmengestell
- 20: Schaltschränke
- x: Hauptströmungsrichtung
- y: Drehachse des Radiallüfters

## Patentansprüche

1. Kühlgerät (1) für die Schaltschrankkühlung, mit einer Lufteinlassseite (2) für Warmluft und einer Luftauslassseite (3) für gekühlte Luft, wobei zwischen der Lufteinlassseite (2) und der Luftauslassseite (3) ein Wärmetauscher (4) und mindestens eine Lüftereinheit (5) mit einem Radiallüfter (6) angeordnet ist, und wobei die Lüftereinheit (5) zwischen der Lufteinlassseite (2) und der Luftauslassseite (3) einen Luftstrom durch den Wärmetauscher (4) mit einer Hauptströmungsrichtung (x) erzeugt, wobei die Lüftereinheit (5) in Hauptströmungsrichtung (x) hinter dem Wärmetauscher (4) angeordnet ist, **dadurch gekennzeichnet, dass** die Lüftereinheit (5) eine Luftleitgeometrie (7) aufweist, so dass aus dem Radiallüfter (6) austretende Luft in die Häuptströmungsrichtung (x) umgeleitet wird.

2. Kühlgerät (1) nach Anspruch 1, bei dem die Lüftereinheit (5) eine im Wesentlichen quaderförmige Lüfterbox (8) aufweist, in der der Radiallüfter (6) aufgenommen ist, wobei die Lüfterbox (8) an mindestens einer von vier parallel zu der Hauptströmungsrichtung (x) und parallel zu einer Drehachse (y) des Radiallüfters (6) ausgerichteten Seiten (9) einen Luftauslass (10) aufweist.

3. Kühlgerät (1) nach Anspruch 2, bei dem die Luftleitgeometrie (7) an den Luftauslass oder die Luftauslässe (10) der Lüfterbox (8) angrenzt und den Luftauslass oder die Luftauslässe (10) von einer Saugseite (11) des Radiallüfters (8) fluidisch abgrenzt.

4. Kühlgerät (1) nach Anspruch 2 oder 3, **dadurch gekennzeichnet, dass** die Luftleitgeometrie (7) als ein Trichter, der um die vier parallel zu der Hauptströmungsrichtung (x) ausgerichteten Seiten (9) herum angeordnet ist, oder als ein Teiltrichter, der um mindestens eine der vier parallel zu der Hauptströmungsrichtung (x) ausgerichteten Seiten (9) herum angeordnet ist, ausgebildet ist.

5. Kühlgerät (1) nach einem der vorangegangenen Ansprüche, bei dem die Luftleitgeometrie (7) im Querschnitt eine 90°-Krümmung aufweist.

6. Kühlgerät (1) nach einem der vorangegangenen Ansprüche, das eine Mehrzahl der Lüftereinheiten (5) aufweist, wobei benachbarte Lüftereinheiten (5) derart zueinander vermittelt angeordnet sind, dass sie entlang ihrer jeweiligen Luftleitgeometrie (7) zumindest abschnittsweise aneinander grenzen.

7. Kühlgerät (1) nach Anspruch 6, bei dem bei benachbarten Lüftereinheiten (5) ein Trennelement (12), das sich zwischen gegenüberliegenden Seiten (9) der benachbarten Lüftereinheiten (5) erstreckt, die Luftauslässe (10) der benachbarten Lüftereinheiten (5) von den Saugseiten (11) der benachbarten Lüftereinheiten (5) fluidisch dicht abtrennt.

8. Kühlgerät (1) nach Anspruch 7, das ein Rahmengestell (13) aufweist, wobei das Rahmengestell (13) an der Luftauslassseite (3) eine Einbauöffnung (14) mit einer horizontalen Weite aufweist, die kleiner als eine horizontale Weite der Lüftereinheiten (5) ist, oder die der horizontalen Weite der Lüftereinheiten (5) entspricht, wobei die Lüftereinheiten (5) in vertikaler Richtung übereinander an dem Rahmengestell (13) montiert sind, und wobei sich das Trennelement (12) über die gesamte horizontale Weite des Kühlgeräts (1) erstreckt.

9. Kühlgerät (1) nach einem der vorangegangenen Ansprüche, bei dem der Radiallüfter (6) ein Radiallüfter mit rückwärts gekrümmten Schaufeln ist.

## Claims

1. Cooling device (1) for cooling a switchgear cabinet, comprising an air inlet side (2) for warm air and an air outlet side (3) for cooled air, wherein a heat exchanger (4) and at least one fan unit (5) having a radial fan (6) are located between the air inlet side (2) and the air outlet side (3), and wherein the fan unit (5) creates an air stream through the heat exchanger (4) having a main flow direction (x) between the air inlet side (2) and the air outlet side (3), wherein the fan unit (5) is located in the main flow direction (x) behind the heat exchanger (4), **characterized in that** the fan unit (5) comprises an air guide geometry (7), so that air exhausted from the radial fan (6) is redirected into the main flow direction (x).

2. Cooling device (1) according to claim (1), wherein the fan unit (5) comprises an essentially ashlar-formed fan box (8) in which the radial fan (6) is received, wherein the fan box (8) comprises an air outlet (10) at at least one of four sides (9) oriented parallel with respect to the main flow direction (x) and parallel with respect to a rotational axis (y) of the radial fan (6).

3. Cooling device (1) according to claim 2, wherein the air guide geometry (7) adjoins to the air outlet or the air outlets (10) of the fan box (8), and fluidically separates the air outlet or the air outlets (10) of the intake (11) of the radial fan (6).

4. Cooling device (1) according to claim 2 or 3, **characterized in that** the air guide geometry (7) is formed as a funnel that surrounds the four sides (9) oriented parallel with respect to the main flow direction (x) or is formed as a partial funnel that surrounds at least one of the four sides (9) that are oriented parallel with respect to the main flow direction (x).

5. Cooling device (1) according to one of the preceding claims, wherein the air guide geometry (7) comprises in its cross section a 90°-curvature.

6. Cooling device (1) according to one of the preceding claims, comprising a plurality of the fan units (5), wherein adjacent fan units (5) are arranged in such a way with respect to each other that they adjoin to each other at least in sections along their respective air guide geometry (7).

7. Cooling device according to claim 6, wherein at adjacent fan units (5) a separative element (12) that extends between opposing sides (9) of the adjacent fan units (5) separates fluidically tight the air outlets (10) of the adjacent fan units (5) from the intakes (11) of the adjacent fan units (5).

8. Cooling device (1) according to claim 7, comprising a rack (13), wherein the rack (13) comprises at the air outlet side (3) a mounting opening (14) having a horizontal width that is smaller than a horizontal width of the fan units (5) or that is equal to the horizontal width of the fan units (5), wherein the fan units (5) are mounted on the rack (13) in vertical direction one above the other, and wherein the separative element (12) extends over the entire horizontal width of the cooling device (1).

9. Cooling device (1) according to one of the preceding claims, wherein the radial fan (6) is a radial fan comprising backward curved blades.

## Revendications

1. Appareil de refroidissement (1) pour le refroidissement d'une armoire de commande, avec un côté d'entrée d'air (2) pour l'air chaud et un côté de sortie d'air (3) pour l'air refroidi, un échangeur de chaleur (4) et au moins une unité de ventilateur (5) avec un ventilateur radial (6) étant disposés entre le côté d'entrée d'air (2) et le côté de sortie d'air (3), et l'unité de ventilateur (5) générant, entre le côté d'entrée d'air (2) et le côté de sortie d'air (3), un flux d'air à travers l'échangeur de chaleur (4) avec une direction d'écoulement principale (x), l'unité de ventilateur (5) étant disposée dans la direction d'écoulement principale (x) derrière l'échangeur de chaleur (4), **caractérisé en ce que** l'unité de ventilateur (5) présente une géométrie de guidage d'air (7) de façon à ce que l'air sortant du ventilateur radial (6) soit dévié dans la direction d'écoulement principale (x).

2. Appareil de refroidissement selon la revendication 1, dans lequel l'unité de ventilateur (5) comprend un caisson de ventilateur (8) de forme globalement parallélépipédique, dans lequel est logé le ventilateur radial (6), le caisson de ventilateur (8) comprenant, au niveau d'au moins un parmi quatre côtés (9) orientés parallèlement à la direction d'écoulement principale (x) et parallèlement à un axe de rotation (y) du ventilateur radial (6), une sortie d'air (10).

3. Appareil de refroidissement selon la revendication 2, dans lequel la géométrie de guidage d'air (7) est adjacente à la sortie d'air ou aux sorties d'air (10) du caisson de ventilateur (8) et est adjacente, de manière fluidique, à la sortie d'air ou aux sorties d'air (10) d'un côté d'aspiration (11) du ventilateur radial (8).

4. Appareil de refroidissement selon la revendication 2 ou 3, **caractérisé en ce que** la géométrie de guidage d'air (7) est conçue comme un entonnoir, qui est disposé autour des quatre côtés (9) orientés parallèlement à la direction d'écoulement principale (x) ou comme un entonnoir partiel qui est disposé autour d'au moins un des quatre côtés (9) orientés parallèlement à la direction d'écoulement principale (x).

5. Appareil de refroidissement (1) selon l'une des revendications précédentes, dans lequel la géométrie de guidage d'air (7) présente une section transversale avec une courbure à 90°.

6. Appareil de refroidissement (1) selon l'une des revendications précédentes, qui comprend une pluralité d'unités de ventilateurs (5), des unités de ventilateurs (5) adjacentes étant disposées de manière centrée les unes par rapport aux autres de façon à ce qu'elles se touchent au moins sur certaines portions le long de leur géométrie de guidage d'air (7).

7. Appareil de refroidissement (1) selon la revendication 6, dans lequel, dans des unités de ventilateurs (5) adjacentes, un élément de séparation (12), qui s'étend entre des côtés (9) opposés des unités de ventilateurs (5) adjacentes, séparé de manière fluidiquement étanche les sorties d'air (10) des unités de ventilateurs (5) adjacentes à partir des côtés d'aspiration (11) des unités de ventilateurs (5) adjacentes.

8. Appareil de refroidissement (1) selon la revendication 7, qui comprend un châssis (13), le châssis (13) comprenant, au niveau du côté de sortie d'air (3), une ouverture de montage (14) avec une dimension horizontale inférieure à une dimension horizontale des unités de ventilateurs (5), ou qui correspond à la dimension horizontale des unités de ventilateurs (5), les unités de ventilateurs (5) étant montés dans la direction verticale les unes sur les autres sur le châssis (13) et l'élément de séparation (12) s'étendant sur toute la dimension horizontale de l'appareil de refroidissement (1).

9. Appareil de refroidissement (1) selon l'une des revendications précédentes, dans lequel le ventilateur radial (6) est un ventilateur radial avec des pales incurvées vers l'arrière.
